# EUROPEAN PATENT SPECIFICATION

(11) **EP 4 602 411 B1**
(45) Date of publication and mention of the grant of the patent: **02.12.2026**
(21) Application number: 23789386.2
(22) Date of filing: 11.10.2023
(51) Int. Cl.: G02B 6/10, G02B 6/132, C23C 14/00

(54) **METHOD FOR MANUFACTURING AN ALUMINIUM NITRIDE OPTICAL WAVEGUIDE**
VERFAHREN ZUR HERSTELLUNG EINES OPTISCHEN WELLENLEITERS AUS ALUMINIUMNITRID
PROCÉDÉ DE FABRICATION D'UN GUIDE D'ONDES OPTIQUE EN NITRURE D'ALUMINIUM

(30) Priority: 13.10.2022 NL 2033304
(43) Date of publication of application: 20.08.2025
(73) Proprietor: Aluvia Photonics B.V., 7522 NB Enschede (NL)
(72) Inventor: HENDRIKS, Ward Arnoldus Petrus Marinus, 7522 NB ENSCHEDE (NL); GARCÍA BLANCO, Sonia María, 7522 NB ENSCHEDE (NL); MARDANI, MEHRABAD, Soheila, 7522 NB ENSCHEDE (NL)
(74) Representative: K&L Gates LLP
(86) International application number: PCT/NL2023/050529
(87) International publication number: WO 2024/080870

(56) References cited:
- JARA FREDDY ET AL: "Space exploration of AlN pedestal waveguides for phase shifting applications", PROCEEDINGS OF THE SPIE SPIE, US, vol. 11680, 5 March 2021 (2021-03-05), pages 1168010 - 1168010, XP060142526, ISSN: 0277-786X, ISBN: 9781510657380, DOI: 10.1117/12.2578363
- KUMTORNKITTIKUL C ET AL: "Intersubband transition device using AlN waveguide with GaN/AlN quantum wells", TECHNICAL DIGEST CD-ROM / CONFERENCE ON LASERS AND ELECTRO-OPTICS, QUANTUM ELECTRONICS AND LASER SCIENCE CONFERENCE, CONFERENCE ON PHOTONIC APPLICATIONS, SYSTEMS AND TECHNOLOGIES : LONG BEACH CONVENTION CENTER, LONG BEACH, CALIFORNIA, USA ; CLEO/QELS, 21 May 2006 (2006-05-21), pages 1 - 2, XP031394555, ISBN: 978-1-55752-813-1
- CHEN HONG ET AL: "Study of Crystalline Defect Induced Optical Scattering Loss inside AlN Waveguides in UV-Visible Spectral Wavelengths", 2019 CONFERENCE ON LASERS AND ELECTRO-OPTICS (CLEO), OSA, 5 May 2019 (2019-05-05), pages 1 - 2, XP033569856, DOI: 10.23919/CLEO.2019.8749725
- ALDEN DORIAN ET AL: "Quasi-phase-matched second harmonic generation of UV light using AlN waveguides", APPLIED PHYSICS LETTERS, AMERICAN INSTITUTE OF PHYSICS, 2 HUNTINGTON QUADRANGLE, MELVILLE, NY 11747, vol. 114, no. 10, 14 March 2019 (2019-03-14), XP012236209, ISSN: 0003-6951, [retrieved on 20190314], DOI: 10.1063/1.5087058
- GAVIN N WEST ET AL: "Low-loss integrated photonics for the blue and ultraviolet regime", ARXIV.ORG, CORNELL UNIVERSITY LIBRARY, 201 OLIN LIBRARY CORNELL UNIVERSITY ITHACA, NY 14853, 1 August 2018 (2018-08-01), XP081426864
- TSUNG-JU LU ET AL: "Aluminum nitride integrated photonics platform for the ultraviolet to visible spectrum", OPTICS EXPRESS, vol. 26, no. 9, 16 April 2018 (2018-04-16), pages 11147, XP055723434, DOI: 10.1364/OE.26.011147

## Description

The present application concerns a method for manufacturing an optical waveguide. The present application further concerns an optical waveguide, preferably manufactured by such method.

Integrated photonics has become ubiquitous as its development opens opportunities for improved capabilities in applications over well-developed microelectronic technologies. Especially, as ultra-low loss waveguides are realized, a myriad of applications for photonics integrated circuits can be explored, among others, quantum computing, microwave photonics, biosensing, and non-linear sources. Of the materials investigated for integrated photonics, aluminium oxide, Al2O3, has emerged as a promising platform material due to its large transparency window, low propagation losses, and high rare-earth solubility.

Another material investigated is aluminium nitride, AIN, in part due to its transparency window covering more of the UV spectrum (e.g. down to 150 nanometre, compared to 200 nanometre for aluminium oxide).

Low losses of 0.04 ± 0.02 dB/cm in the C-band have been demonstrated in amorphous Al2O3 planar slab waveguides deposited by atomic layer deposition, ALD. For near UV applications, losses below 3 dB/cm have been demonstrated in high confinement single transverse mode ALD-grown and fully etched Al2O3 waveguides. These results demonstrate the wide wavelength range available to an Al2O3 based integrated photonics platform.

A major disadvantage of ALD-grown Al2O3 layers, when compared to layers grown using reactively sputtered Al2O3, is the order of magnitude difference in deposition rate. Slab losses of sputtered Al2O3 reported to date are known as low as 0.1 dB/cm with fully etched waveguide losses below 0.2 dB/cm in the C-band. Therefore, a reduction of the losses in sputtered Al2O3 is required to compete with both ALD-grown Al2O3, as well as the more established silicon nitridebased platform with demonstrated losses as low as 1 dB/m at 1550 nanometre for high confinement waveguides.

Known from the art is that a waveguide may be manufactured by providing a substrate, depositing an aluminium oxide waveguide core on the substrate, and arranging a cladding layer on the deposited aluminium oxide waveguide core. Here, it is noted that arranging the cladding layer comprises at least one processing step during which the deposited aluminium oxide waveguide core is subjected to a given maximum temperature.

It is known from the art that an optical waveguide with an aluminium oxide waveguide core made of amorphous aluminium oxide tends to show a high optical performance and/or low losses. At the same time, it is known that when deposited amorphous aluminium oxide waveguide cores are subjected to high temperatures, such as those occurring during annealing, optical performance markedly deteriorates.

The skilled person will be aware that optical losses in an optical waveguide are determined, not just by losses in the waveguide core, but also by losses in the cladding layer.

Optical losses in cladding layers may vary between different materials. For example, Tetraethyl orthosilicate, TEOS, is known to display relatively low optical losses. However, for the manufacturing of such a TEOS cladding layer, a high temperature annealing step is typically required. When combining the TEOS cladding layer with an amorphous aluminium oxide waveguide core, a problem therefore arises in that the benefit of the optical quality of the TEOS cladding layer is mitigated by the losses in optical performance of the amorphous aluminium oxide waveguide core due to the high temperatures involved when using a TEOS cladding layer on the amorphous aluminium oxide waveguide core.

There may also be other types of cladding layers that, to be arranged on the deposited aluminium oxide waveguide core, require processing steps during which said aluminium oxide waveguide core is subjected to high temperatures, resulting in the aforementioned loss in optical performance of the aluminium oxide waveguide cores. Hereinafter, cladding layers that require a high-temperature step performed at 800 degrees Celsius or higher during or after deposition are referred to as high-temperature cladding layers.

Accordingly, a problem exists when combining a known aluminium oxide waveguide core with a high-temperature cladding layer. This problem prevents further reductions in optical losses for aluminium oxide waveguide cores. Consequently, high-temperature cladding layers cannot be combined with known amorphous aluminium oxide waveguide cores, even though both components by themselves show high optical performance and/or low losses, and thus seem to be advantageous to use in combination.

This problem, for example, occurs in WEST, Gavin N., et al. Low-loss integrated photonics for the blue and ultraviolet regime. Apl Photonics, 2019, 4.2: 026101. This paper discusses amorphous aluminium oxide, or alumina, films deposited using atomic layer deposition. The alumina films are grown either on bare silicon substrates or on thick (3.2 «m) silicon dioxide on silicon (also known as thermal oxide), at 300 degrees Celsius growth temperature. Optical loss in the films was measured using a prism coupling method (Metricon) for wavelengths of 633 nanometres and 405 nanometres. Before annealing, optical loss was measured at less than 0.3 decibel per centimetre (dB/cm) or 30 decibel per metre (dB/m).

The authors indicate that high temperature annealing causes formation of dense polycrystalline y-phase Al2O3. High temperatures being above 800 degrees Celsius. The disclosed alumina films, after being annealed at 900 degrees Celsius and 1100 degrees Celsius, are polycrystalline and are said to exhibit optical losses of more than 20 dB/cm, or 2000 dB/m. And while this problem is exemplified here for aluminium oxide waveguide cores, the applicant finds that while manufacturing aluminium nitride (AlN) waveguide cores, the same or at least very similar behaviour and problems occur. Further optical waveguides are already known in the prior art and discussed in scientific papers, in particular according to "Intersubband transition device using AIN waveguide with GaN/AIN quantum wells" of Kumtornkittikul et. al 2006; "Study of Crystalline Defect Induced Optical Scattering Loss inside AIN Waveguides in UV-visible Spectral Wavelengths" of Chen Hong et. al. 2019; "Quasi-phase-matched second harmonic generation of UV light using AlN waveguides" of Alden Dorian et. al. 2019; or "Aluminium nitride integrated photonics platform for the ultraviolet to visible spectrum" of Tsung-ju Lu et. Al. 2018.

An object of the present invention is to provide a method for manufacturing an optical waveguide comprising an aluminium nitride waveguide core and high-temperature cladding layer in which at least one of the abovementioned problems is at least partially solved. According to the present invention, this object is achieved with a method as defined in claim 1.

In some embodiments, an increase in size is considered significant when it is an increase of about 100% or more. At the same time, any increase in size is detrimental, so in preferred embodiments, an increase is significant when between about 100% and about 50%.

The Applicant has found that by deliberately allowing nano-crystallites to form during deposition, an aluminium nitride waveguide core can be manufactured that has similar optical performance as one made of amorphous material, while being able to maintain said optical performance up to higher temperatures during subsequent processing steps.

The Applicant found that Rayleigh scattering plays an important role in deposited aluminium nitride layers. Firstly, Rayleigh scattering may occur as a result of differences in dielectric constant inside the aluminium nitride layer. Secondly, Rayleigh scattering may occur when crystallites are formed having a size that is at least comparable to the wavelength of the light in the layer. Other sources of optical scattering become relevant when crystallites have an even larger size.

When depositing at relatively low temperatures, no significant crystallization occurs, an amorphous layer will be achieved, and the optical losses of such layer will be relatively low. However, when such an amorphous aluminium nitride layer is subsequently subjected to a high temperature, e.g. 800 degrees Celsius and up, crystallization will occur. In the amorphous material, crystallites will start to grow. Since these crystallites grow in amorphous material, they can grow freely, e.g. amorphous material surrounding a crystallite can be absorbed into this crystallite with relatively little energy, and in every direction. The resulting crystallites will be relatively large and have different dielectric properties from the remaining amorphous material. Optical scattering including Rayleigh scattering will therefor occur and optical performance will be degraded.

When depositing at moderately high temperatures, crystallization occurs and crystallites will be formed in an otherwise amorphous layer. In this case, local differences in the dielectric constant between the amorphous and nano-crystalline parts of the layer will exists as well. Rayleigh scattering associated with these differences will result in reduced optical performance. Furthermore, when this layer is subjected to high temperatures, for example during an annealing step, the existing nano-crystallites will grow by absorbing the amorphous material that surrounds them thus causing relatively large crystallites and increased optical scattering losses.

When depositing at relatively high temperatures, crystallization will occur to such an extent that almost the entire deposited layer is filled with nano-crystallites. In this case, local differences in the dielectric constant will be largely absent as the amount of remaining amorphous aluminium nitride is small. Optical scattering in such layers is relatively low.

Without being bound by theory, the Applicant notes that the energy required for transforming the abovementioned aluminium nitride layer with a large amount of relatively small crystallites into a layer with a small amount of relatively large crystallites is too high to be reached during the processing steps required to arrange a cladding layer. That such a waveguide core is achieved can be confirmed by subjecting it to the given maximum temperature. No significant changes in the optical performance will occur, as very little crystal growth will occur inside the layer.

By deliberately allowing nano-crystallites to form, no to little amorphous material is present. This means fewer local difference in dielectric properties, so less optical scattering. Also, there is less amorphous material for nano-crystallites to absorb and grow. Hence, in the aluminium nitride waveguide core deposited according to the invention, existing nano-crystallites cannot grow as easily and as freely, thereby significantly limiting their growth and avoiding the aforementioned optical scattering.

Without being bound by theory, the Applicant considers that the energy required for the growth in size of nano-crystallites that are surrounded predominantly by other nano-crystallites is larger than energy required for the growth in size of nano-crystallites that are surrounded predominantly by amorphous material. This is a further reason why, when the deposition of the aluminium nitride waveguide core is performed such that nano-crystallites are formed, formation of larger crystallites during subsequent processing steps can be prevented or at least limited. This allows for arranging a high-temperature cladding layer on the aluminium nitride waveguide core without significant degradation of the optical performance of the aluminium nitride waveguide core. As a result, waveguides having an aluminium nitride waveguide core can be manufactured that display improved optical performance and/or decreased losses.

The size of the nano-crystallites formed during deposition strongly impacts the amount of optical scattering. The Applicant found that by forming the nano-crystallites such that the given maximum temperature lies in a range between 800 and 1400 degrees Celsius, advantageous optical performance of the optical waveguide can be obtained. A maximum temperature that is lower than 800 degrees Celsius would indicate that a relatively large amount of amorphous aluminium nitride would be available after deposition of the waveguide core that would transform in large crystallites when arranging the cladding layer. On the other hand, a maximum temperature that is higher than 1400 degrees Celsius would risk deterioration of the aluminium nitride waveguide core, or other components included in the waveguide comprising said aluminium nitride waveguide core.

It is noted that the given maximum temperature more preferably lies in a range between 1000 and 1300 degrees Celsius and is more preferably about 1150 degrees Celsius.

Arranging the cladding layer may comprise depositing the cladding layer on the aluminium nitride waveguide core and said at least one processing step may comprise annealing the combination of the substrate, deposited aluminium nitride waveguide core, and deposited cladding layer at the given maximum temperature.

The nano-crystallites in the aluminium nitride waveguide core after the deposition and before the annealing can be between 1 nanometre and 30 nanometre in size, and preferably between 1 nanometre and about 10 nanometre in size. Furthermore, the nano-crystallites in the aluminium nitride waveguide core may form at least 40% by weight of the aluminium nitride waveguide core after the deposition and before the annealing, preferably at least 70%, and more preferably at least 90%. Additionally, the nano-crystallites in the aluminium nitride waveguide core after the annealing can be between 1 nanometre and 30 nanometre in size, and preferably between 1 nanometre and 10 nanometres. Furthermore, the nano-crystallites in the aluminium nitride waveguide core may form at least 50% by weight of the aluminium nitride waveguide core after the annealing, preferably at least 75%, and more preferably at least 99%.

The at least one processing step may comprise depositing the cladding layer on the aluminium nitride waveguide core at the given maximum temperature. In this embodiment, the high-temperature heating step is applied during the deposition of the cladding layer itself. The nano-crystallites in the aluminium nitride waveguide core after the depositing the cladding layer can be between 1 nanometre and 30 nanometre in size, and preferably between 1 nanometre and 10 nanometres. Furthermore, the nano-crystallites in the aluminium nitride waveguide core may form at least 50% by weight of the aluminium nitride waveguide core after the annealing, preferably at least 75%, and more preferably at least 99%.

The aluminium nitride waveguide core may be deposited using any one of reactive sputter deposition, atomic layer deposition, evaporation, or pulsed laser deposition. Other means of arranging the aluminium nitride waveguide core are not excluded.

The cladding layer may comprise high-temperature cladding layer. Such cladding layers are characterized in that these layers are arranged at relatively high temperatures and/or require heating steps after deposition at relatively high temperatures when compared to a temperature at which the aluminium nitride waveguide core is deposited. Examples of such cladding layers are a TEOS layer, a Silicon oxynitride layer, an aluminium oxide layer, or a polymer layer. Such layers have relatively low optical losses when compared to lowtemperature cladding layers. The high- temperature cladding layer can be arranged using any one of plasma-enhanced vapor deposition, low-pressure chemical vapor deposition, evaporation, sputtering, or atomic layer deposition.

The substrate may comprise a silicon substrate, silicon nitride substrate, a silicon thermal oxide substrate, a quartz substrate, or a sapphire substrate.

The aluminium nitride waveguide core may be stoichiometric. Additionally or alternatively, the aluminium nitride waveguide core may comprise AlxNy, wherein 0.8 〈 x 〈 1.1 and 0.9 〈 y 〈 1.2, such as x = 0.9, and y = 1.1, and preferably x = 1, and y = 1.

The optical waveguide can be a slab waveguide or channel waveguide. The present application does not exclude other types of waveguides.

In further embodiments, depositing the aluminium nitride waveguide core on the substrate may further comprises one or more of the steps of reducing surface roughness of the aluminium nitride waveguide core, for example using chemical mechanical polishing, and defining a shape and/or size of the aluminium nitride waveguide core using at least one of lithography and etching.

The method may further comprise the step of, at a deposition rate for aluminium nitride, depositing aluminium nitride at varying substrate temperatures and/or varying substrate bias voltages on respective substrates. For each deposited aluminium nitride layer, its optical performance is measured. The method may further comprise selecting, as optimal settings, said deposition rate, substrate temperature and substrate bias voltage with which the aluminium nitride layer was manufactured that had the best optical performance. These optimal settings can be used when depositing the aluminium nitride waveguide core for manufacturing an optical waveguide as described above.

According to a second aspect, the present invention provides an optical waveguide as defined in independent claim 13, wherein the optical wave guide comprises a substrate, an aluminium nitride waveguide core arranged on the substrate, and a cladding layer arranged on the aluminium nitride waveguide core. According to the present invention, the aluminium nitride waveguide core comprises nano-crystallites that are between 1 nanometre and 30 nanometre in size, preferably between 1 nanometre and 10 nanometre in size. The nano-crystallites form at least 50% by weight of the aluminium nitride waveguide core, preferably at least 75%, and more preferably at least 99%, and the cladding layer comprises a high-temperature cladding layer. The high-temperature cladding layer may comprise at least one of a TEOS layer and a Silicon oxynitride layer. Additionally or alternatively, the optical waveguide is a slab waveguide, or a channel waveguide.

Next, the present invention will be described by referring to the appended drawings, wherein identical reference signs will be used to refer to the same or similar components, and wherein:
Figure 1 shows a flowchart of a method for manufacturing an optical waveguide in accordance with the present invention;
Figure 2 shows a cross-section of a slab waveguide in accordance with the present invention;
Figure 3 shows a flowchart of a preferred embodiment of the method of figure 1;
Figure 4 shows an example of a reactive co-sputtering system that may be configured to deposit an aluminium oxide waveguide core;
Figure 5 illustrates TEM pictures of deposited aluminium oxide waveguide cores for various substrate temperatures;
Figures 6a and 6b illustrate AFM pictures of a deposited aluminium oxide waveguide cores for various substrate temperatures;
Figure 7 shows a graph relating, on the X-axis, deposition temperatures for aluminium oxide waveguide cores, and, on the Y-axis, measured refractive index thereof, and a graph relating, for a number of deposition temperatures, on the X-axis, a wavelength of light propagated through aluminium oxide waveguide cores deposited at said temperatures, and, on the Y-axis, measured propagation losses therein.
Figure 8a shows a graph relating, on the X-axis, the temperature at which a waveguide core is deposited, to, on the Y-axis, the size of crystallites formed in said aluminium oxide waveguide core;
Figure 8b shows a graph relating, on the X-axis, the temperature at which a waveguide core is deposited, to, on the Y-axis, the percentage by weight of the waveguide core that is in a particular phase, specifically amorphous (A) or crystalline (C);
Figure 8c shows a graph relating, on the X-axis, the temperature at which a waveguide core is deposited, to, on the Y-axis, optical losses achieved in said waveguide core;
Figures 9a and 9b both show graphs relating, on the X-axis, the distance over which light propagated through a waveguide core, to, on the Y-axis, intensity of said light.

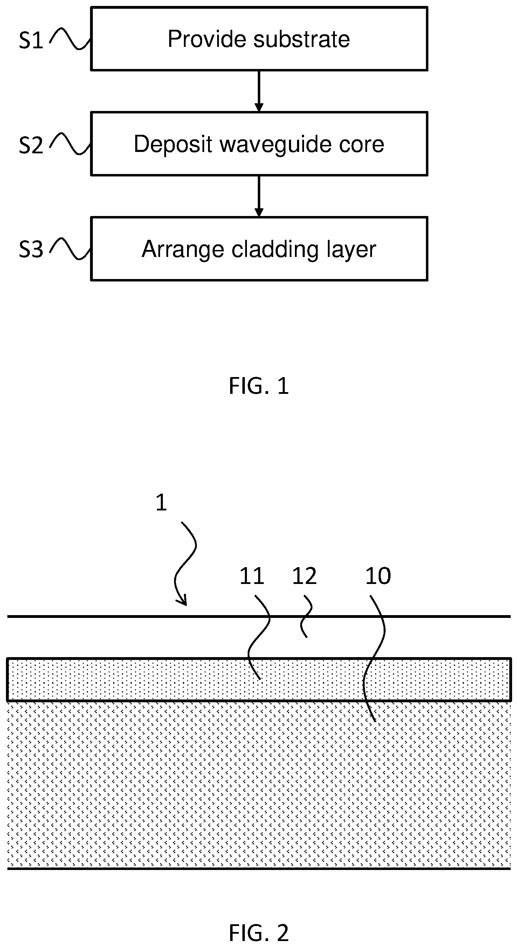

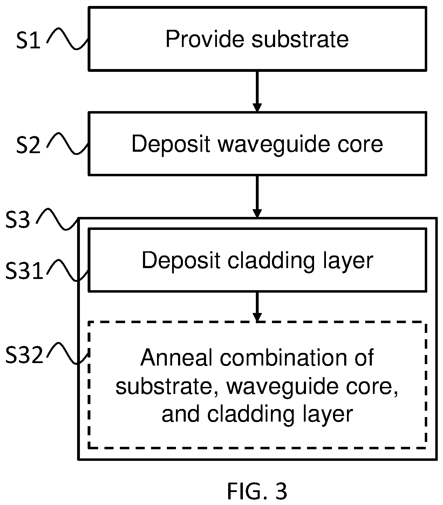

Figure 1 shows a flowchart including steps S1 -S3 of one embodiment of a method for manufacturing an optical waveguide according to the present invention. Figure 2 shows a schematic cross-section of an optical waveguide, as, for example, can be manufactured with the method according to the invention. Figure 3 shows a flowchart of a preferred embodiment of said method.

In a step S1, a substrate 10 is provided. In a next step S2, an aluminium nitride waveguide core 11 is deposited on the substrate. The aluminium nitride waveguide core 11 may be deposited directly onto the substrate. Embodiments not within the scope of the claims are also conceivable, in which the aluminium oxide waveguide core 11 is deposited on the substrate, with other layers in between. An exemplary embodiment is one in which waveguide cores are stacked. A further exemplary embodiment not within the scope of the claims is one, in which the aluminium oxide waveguide core 11 is deposited on an aluminium oxide layer that, in turn, is deposited on the substrate. A further exemplary embodiment is one in which the substrate is a sapphire, preferably crystalline sapphire substrate, and in which an SiO2 layer is arranged on the substrate and in which the aluminium oxide waveguide core is deposited on the SiO2 layer.

Specifically, aluminium nitride waveguide core 11 is deposited such that nano-crystallites are formed therein. In a next step S3, a cladding layer 12 is arranged on aluminium nitride waveguide core 11. During at least one processing step required to arrange cladding layer 12, aluminium nitride waveguide core 11 is subjected to a given maximum temperature, which is about 800 degrees Celsius or higher, and preferably between 800 degrees and 1400 degrees Celsius.

The temperature the aluminium nitride waveguide core would be required to have for significantly increasing the size of the formed nano-crystallites during arranging the cladding layer exceeds this given maximum temperature. Alternatively said, the lowest temperature at which the formed nano-crystallites will significantly increase in size, exceeds the given maximum temperature. Aluminium nitride waveguide core 11 can therefore have said maximum temperature without said significant increase in size occurring.

Increasing the maximum temperature beyond 1400 degrees Celsius risks deterioration of aluminium nitride waveguide core 11. The skilled person will appreciate that around 1400 degrees Celsius the glass transition temperature of aluminium nitride starts, so subjecting the waveguide core to this temperature may cause reflow of the structure. Moreover, such a maximum temperature may also deteriorate the performance of the other components of the waveguide, depending on the materials used. Substrate 10 may be made of silicon, which may start to melt around 1400 degrees Celsius. Substrate 10 may also comprise silicon dioxide, in which, when exposed to such temperatures, local density fluctuations may form and these cause scattering, thus degrading performance.

The mentioned increase in size of said nano-crystallites may be considered significant when about 100% or more, preferably when between about 100% and about 50%.

Now referring to figure 3, step S3 of arranging the cladding layer may comprise a step S31 of depositing a cladding layer 12 on aluminium nitride waveguide core 11. Step 31 may be the processing step during which aluminium nitride waveguide core 11 is subjected to the given maximum temperature. This may for example apply in embodiments where a polymerbased cladding layer is deposited.

Alternatively, a high-temperature step is not part of the deposition of the cladding layer but part of subsequent heating step. In figure 3, an example of such subsequent step is provided as step S32 in which the combination of substrate 10, deposited aluminium nitride waveguide core 11, and arranged cladding 12 layer is annealed thereby subjecting aluminium nitride waveguide core 11 to the given maximum temperature. This applies for example in embodiments where a TEOS cladding layer is deposited.

It should be noted that various other steps can be performed in between the deposition of aluminium nitride waveguide core 11 and the arrangement of cladding layer 12. For example, the deposited aluminium nitride layer can be subjected to chemical mechanical polishing to reduce surface roughness and to lithography and etching steps to define a channel waveguide or other type of waveguide.

For any embodiment (e.g. methods and/or devices) relating to aluminium nitride waveguide core 11, an alternative embodiment (not within the scope of the claims) may be considered in which the waveguide core is instead made of aluminium oxide. The embodiments explained in relation to figures 1-3, for example, can also be applied for manufacturing a waveguide comprising an aluminium oxide waveguide core. The skilled person will be aware of how the following specification of a manufacturing process for an aluminium oxide waveguide core, can and/or should be adapted for manufacturing an aluminium nitride waveguide core.

The Al2O3 thin films used in embodiments (not within the scope of the claims) can be deposited by reactive sputtering onto a silicon wafer having an 8 micrometres oxide buffer layer. The advantage of reactive sputtering exploited here is a result of the energy available per adatom on the substrate. The adatoms landing on the substrate have a high mobility, resulting in high-density layer morphologies available at relatively low substrate temperatures and high deposition rates. This allows for the deposition of high-density amorphous Al2O3 layers at CMOS compatible wafer temperatures, with slab waveguide propagation losses below 0.1 dB/cm at 1550 nm.

While several low-loss propagation slab waveguide results for Al2O3 optical waveguides have been achieved, no link with layer morphology has been demonstrated in the prior art. The Applicant realized that, given the complexity of reproducing reactive sputter deposition processes, an understanding of the morphology and corresponding propagation losses can facilitate improved reproducibility and layer quality.

The morphology of an Al2O3 layer deposited by reactive sputtering is primarily determined by the available energy per adatom, EP A, and the material properties of the deposited layer. The material properties determining the morphology are the activation energy and diffusion constants that determine the diffusion length of the adatom at a given kinetic energy available per adatom, and the critical nucleation dimension that determines a critical diffusion length required for stable nucleation. While the material properties are a given for an Al2O3 layer, the energy per adatom is a ratio of the deposition rate and the total energy contributions during deposition.

For reactive sputtering, the total energy flux is a linear combination of different contributions. The sputtering process contributions to the energy flux towards the substrate can be classified in at least four groups.

The contributions of the atoms and molecules adhering to the substrate required for Al2O3 layer formation should be considered first. Adatoms that have been accelerated from the target have contributed their kinetic energy as they were adsorbed on the substrate. In addition, when an oxygen molecule is adsorbed, its kinetic energy is also contributed. Even when atoms or molecules are not adsorbed, part of their kinetic energies can still be transferred when colliding with the substrate. Especially when the gas molecules get energized by collisions with higher velocity ions, this contribution can become significant. Another form of kinetic energy is related to the temperature of the substrate. Furthermore, besides the kinetic energy contributions to the layer formation, the potential energy released by the exothermic chemical reaction forming Al2O3 is a significant contribution.

The three other groups of energy contributions are radiation from the plasma, electrons incident on the substrate, and ions accelerated towards the substrate. Note, that a substrate bias can be applied. Increasing and/or decreasing said bias can be done to increase or decrease the electron and ion bombardment on the substrate.

All the energy contributions add to the available energy per adatom and thus influence the layer morphology and consequent propagation losses.

In an embodiment not within the scope of the claims, the Al2O3 layer can be deposited using an AJA ATC 1500 RF reactive co-sputtering system 100 on 10 centimetre silicon wafers having an 8 micrometre thick thermal oxide buffer layer.

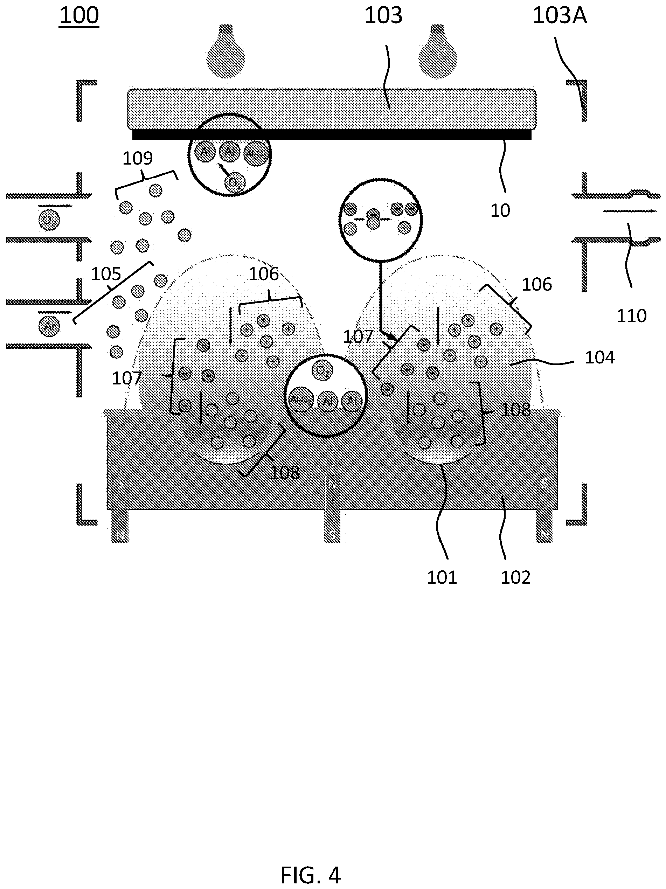

System 100, which is schematically illustrated in figure 4, comprises a target 101 comprising aluminium with a 99.9995 % purity, which is arranged above cathode 102. Opposite to target 101, substrate 10 is arranged on anode 103, which is electrically connected to chamber 103 A. RF power is applied between anode 103 and cathode 102. This causes the generation of a plasma 104 in which supplied Ar atoms 105 are ionized into Ar ions 106 and electrons 107. Ar ions 106 are accelerated towards target 101 under the influence of a self-generated DC bias. At target 101, they will collide with Al atoms thereby generating a stream of Al atoms 108 towards substrate 10. At substrate 10, Al atoms 108 that have deposited onto substrate 10 will react with oxygen molecules 109 to form aluminium oxide.

The main deposition chamber is evacuated through inlet 110 to a base pressure of 0.1 microTorr to prevent incorporation of hydroxide ions in the Al2O3 layer, which induce absorption losses around 750 nm, 970 nm, and 1400 nm.

For the magnetron discharge to be sustained, an equilibrium between the secondary electrons emission from target 101 under ion bombardment and the rate of electrons 107 escaping plasma 104 needs to be maintained. While an RF power source does not directly apply a DC potential difference between cathode 102 and anode 103, electrons 107 in plasma 104 absorb the RF energy much more efficiently than heavier argon ions 106. The high electron mobility causes electrons 107 to be collected on the electrodes. A self-generated DC bias voltage is then a consequence of the asymmetry between target 101 and chamber 103A of sputtering system 100.

A magnetic field is applied using permanent magnets below the target to increase the electron density in plasma 104, thereby increasing the argon ionization rate and reducing the discharge voltage required. In addition, the magnetic field greatly increases the sputter yield by the increase of ionization and therefore bombardment rate of the target.

Sputtering system 100 further comprises heating means, such as infrared heaters 111, for heating substrate 10 either directly or via anode 103 on which substrate 10 is arranged.

Exemplary process conditions for depositing the aluminium oxide waveguide core are listed in the table below.

| Parameter | Value | Unit |
|---|---|---|
| Base Pressure | <0.3 | µTorr |
| Argon Flow | 30 | Sccm |
| Oxygen Flow | 3.0 +/- 0.2 | Sccm |
| Oxygen partial pressure | 0.2 +/- 0.1 | mTorr |
| Pressure | 3.5 +/- 0.1 | mTorr |
| Pump flow | 50 +/- 2 | 1/s |
| Substrate set temperature | 420 460 500 540 580 620 660 | °C |
| Target-substrate distance | 15.2 | Cm |
| Power | 200 | W |

Given the dependence of the layer morphology on available energy per adatom, it is possible to vary the substrate temperature for the purpose of varying the available energy per adatom as it is mostly independent of the other parameters in the process. This allows the investigation of layer morphology as it changes with substrate temperature and the corresponding optical propagation losses in the layers.

The substrate temperatures are set temperatures measured on the substrate holder and are therefore not the exact temperature of the substrate. A calibration of substrate temperature as a function of the set temperature can be provided.

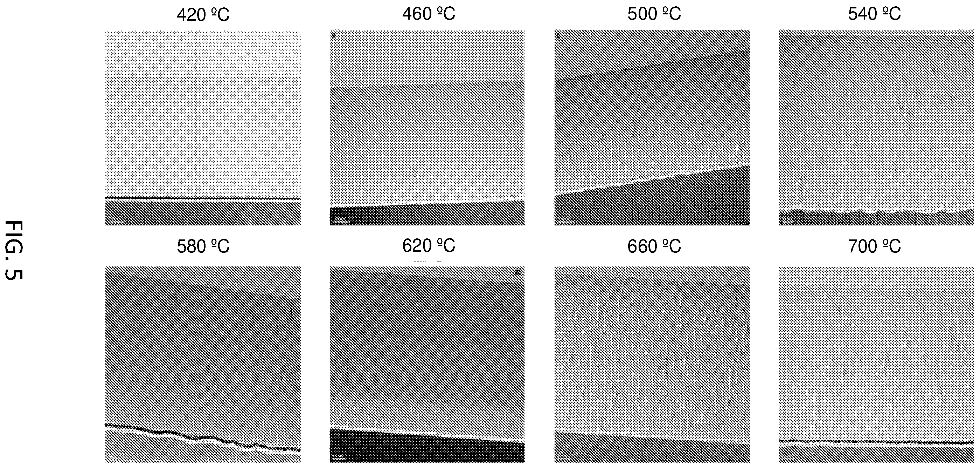

Figure 5 illustrates TEM pictures of a deposited aluminium oxide waveguide layer for various substrate temperatures. The morphology of the layer at the lowest chosen temperature of 420 degrees Celsius is amorphous. As the substrate temperature is increased to 460 degrees Celsius nano-crystallites start to form, of which the density is significantly increased for 500 degrees Celsius and 540 degrees Celsius. As the temperature is increased from 500 to 580 degrees Celsius, the surface roughness increases with ever larger waviness. While the waviness of the surface is still present for the layer deposited at 580 degrees Celsius, a clear transition from a mostly amorphous layer with nano-crystallites to a mostly polycrystalline morphology has occurred. The waviness disappears from a temperature of 620 degrees Celsius as an increasingly polycrystalline morphology is observed with a slight columnar growth profile. As the temperature is further increased to 700 degrees Celsius, no significant difference in the morphology is observed.

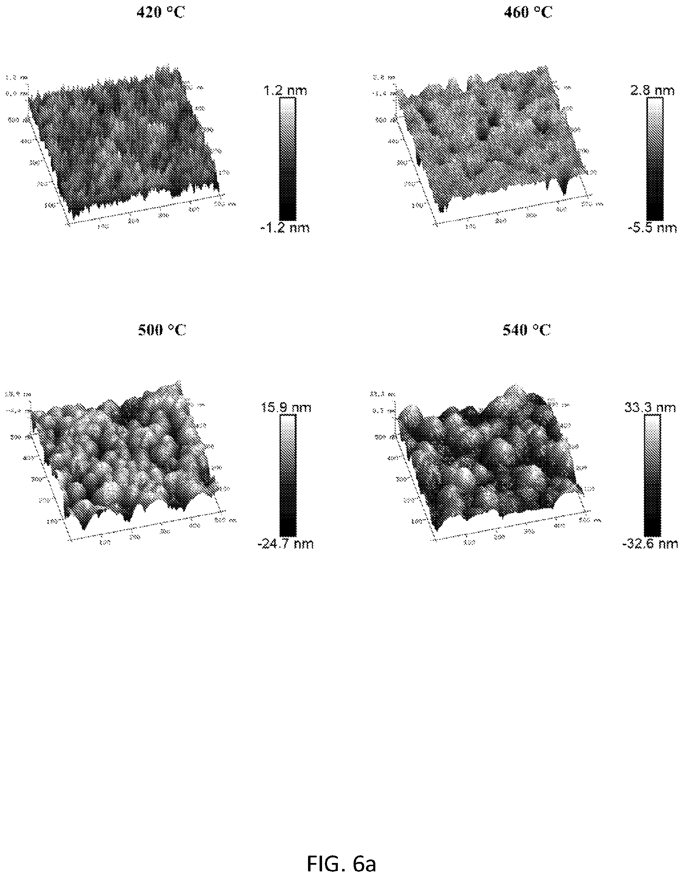

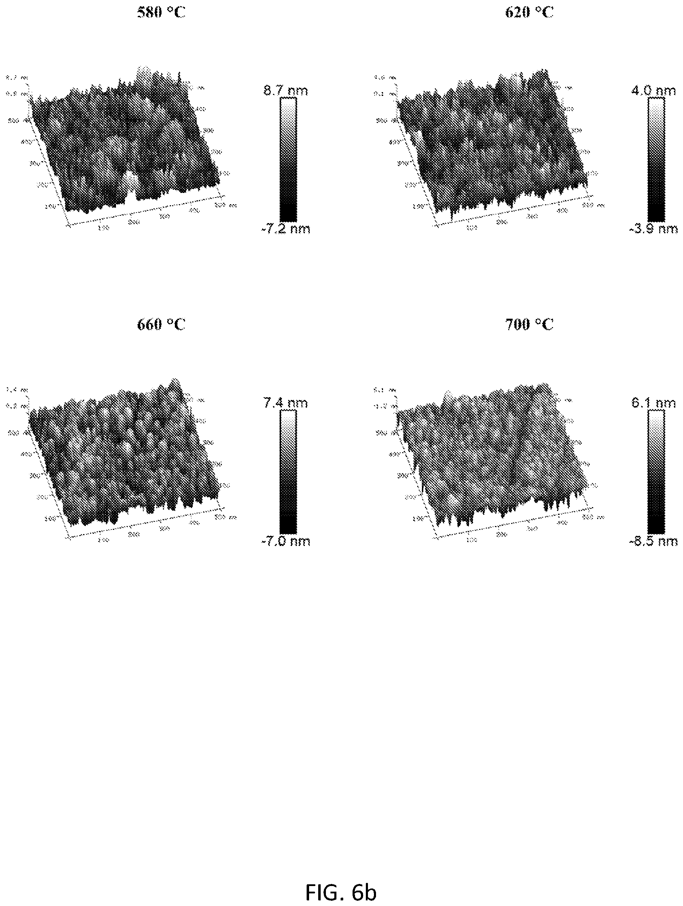

Figures 6a and 6b illustrate AFM measurements of a deposited aluminium oxide waveguide layer for various substrate temperatures. The AFM measurements show the waviness appearing at 500 degrees Celsius (figure 6a, bottom left) , increasing in amplitude at 540 degrees Celsius (figure 6a, bottom right), and reducing and disappearing at 620 degrees Celsius (figure 6b, top right). In addition to the waviness, the layers grown at a temperature from 500 degrees Celsius (figure 6a, bottom left) to 580 degrees Celsius (figure 6b top left) exhibit a decreased refractive index and thickness uniformity.

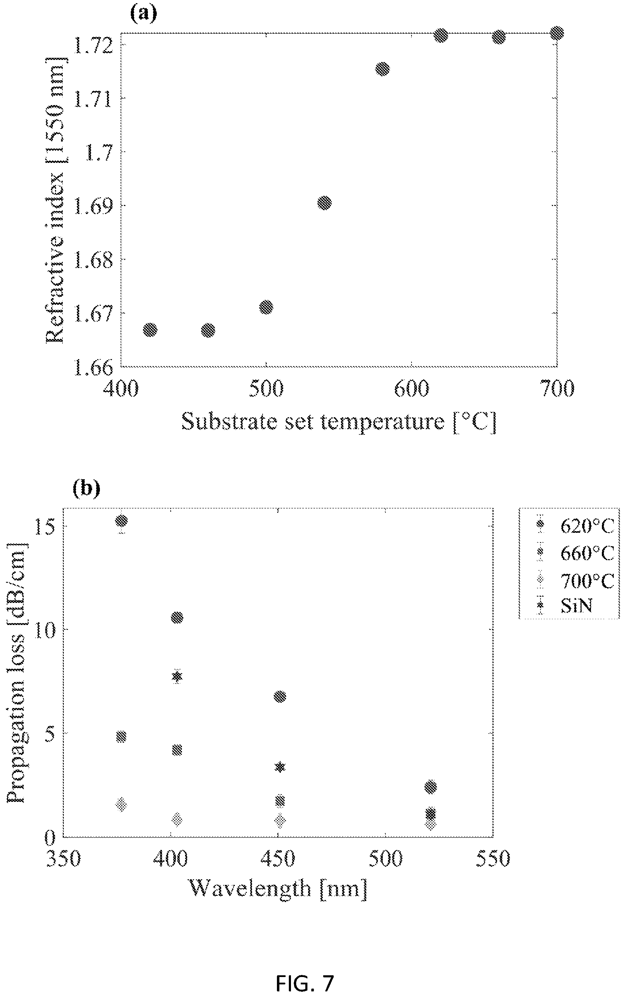

Figure 7, bottom, specifically shows the refractive index of aluminium oxide layers measured by ellipsometry at 1550 nm, for varying deposition temperatures.

The optical propagation losses for each aluminium oxide layer have been investigated using a Metricon 2010/M41, with a fibre loss module. These losses are illustrated in figure, top. Clearly, losses decrease with increasing deposition temperature down to 1.57 dB/cm at 377 nm and 0.84 dB/cm at 403 nm for the layer grown at 700 degrees Celsius substrate temperature.

In embodiments, when depositing an aluminium nitride waveguide core, the exact deposition temperatures may be different from those mentioned in relation to figures 5 and 6, however the applicant does find that the same behaviour occurs. The same changes in morphology, and/or the same trends in refractive index and thickness uniformity can be observed in aluminium nitride waveguide cores, when deposited at varying temperatures. The teachings derived from figures 4-7, while explaining based on the aluminium oxide waveguide core, can also be applied to the aluminium nitride waveguide core embodiment.

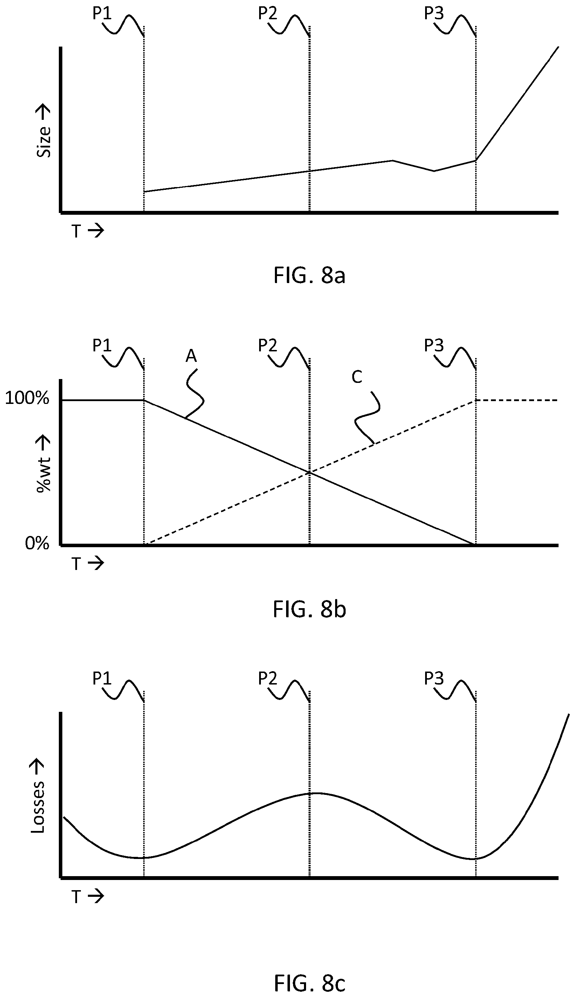

Figures 8a-c each show a graph that relates the deposition temperature at which an aluminium oxide waveguide core 11 is deposited, to various properties of said core 11. On the X- axis of each of these graphs the deposition temperature is shown. The skilled person will appreciate that the exact temperature values at which a particular waveguide core is deposited is strongly machine dependent, e.g. the machine given value for the 'deposition temperature' can deviate from an actual, practically very hard to know, temperature of the waveguide core. However, given a particular machine and a deposition rate that can be achieved, a temperature sweep can be performed to determine exact temperature values at which the behaviour as elucidated in the graphs shown in figures 8a-c occurs.

In the art, there is a clear preference for making dense amorphous Al2O3 waveguide cores as these cores have displayed low optical losses. In figures 8a-8c, the deposition temperature at which such waveguides are achieved is referred to as temperature P1. If, starting from P1, the deposition temperature is decreased, the deposited layer will become less dense and voids will be present in the amorphous aluminium oxide. Said voids may act as scattering objects and may cause losses. If, starting from P1, the deposition temperature is increased, nano-crystallites form in the amorphous material. Said nano-crystallites may act as scattering objects and may cause losses.

As shown in figures 8a-8c, P1 is a local minimum at which a balance is struck between reducing the amount voids and preventing the formation of nano-crystallites. At P1, relatively low losses can be achieved. Known aluminium oxide optical waveguides are based on aluminium oxide layers deposited at temperatures corresponding to P1. However, such layers have the aforementioned disadvantage of being vulnerable to high temperature processing steps that follow the deposition of the aluminium oxide layer.

The Applicant realised that in aluminium oxide optical waveguides deposited at deposition temperatures in a range around P1, the largest losses are caused by local differences in dielectric properties. Both voids and crystallites have different dielectric properties than amorphous aluminium oxide. More voids and/or more crystallites means such local differences occur more often and optical losses will increase.

The Applicant further realised that such local differences will most often occur, and therefore that the losses caused thereby may be at their highest, when the aluminium oxide layer comprises comparable amounts of amorphous material and nano crystallites. This may for example be seen in figure 8b, in which line A describes how much aluminium oxide in the layer, expressed in weight percentage, is in the amorphous phase, and line C describes how much aluminium oxide, expressed in weight percentage, is in the crystalline phase. The skilled person will appreciate that the amount of amorphous material and/or the number of nano-crystallites may also be expressed using other units and/or metrics.

The Applicant further realised that when the deposition temperature is increased, the nano-crystallites will at some temperature overtake the amorphous material as the dominant material in the deposited layer. As the number of discontinuities between amorphous and crystalline aluminium oxide decreases due to the decreasing amount of amorphous aluminium oxide, a reduction in optical losses can be observed beyond a temperature P2. In figure 8b, temperature P2 is chosen as the temperature at which the content of amorphous and crystalline aluminium oxide content is identical for illustrative purposes only.

The reduction in optical losses continues up to the deposition temperature at which substantially all aluminium oxide in the waveguide core takes the form of nano-crystallites and little to none of it is in the amorphous phase. This point may be referred to as P3. Figure 8c further indicates a rectangle R that illustrates the temperature range corresponding to the temperature variation in figure 7, top.

Equivocally, for deposition temperatures between P2 and P3, it is the sporadic presence of volumes of amorphous material in between the otherwise nano-crystalline aluminium oxide that can be considered the cause of scattering. Hence, when further increasing the deposition temperature, less and/or smaller volumes of amorphous material are formed, local differences occur less often, and losses decrease.

The Applicant furthermore realised that, while in the range P1 and P3, more and more aluminium oxide takes on the shape of nano-crystallites, that a size of the individual nano-crystallites does not increase significantly. This is conceptually reflected in figure 8a. Only when deposition temperatures above P3 are used, there may be a significant increase in the size of the individual crystallites while the percentage of aluminium oxide included in crystallites in itself stays the same. It should be noted that no size is indicated for deposition temperatures below P1 as almost no nano-crystallites are present. Increasing the temperature beyond P3 will cause nano-crystallites to combine into large crystallites. These relatively large crystallites cause an increase in optical scattering, thereby increases the optical losses in the layer. As such, at temperature P3 a local minimum can be observed in the losses that is comparable to the minimum at temperature P1. However, unlike deposited aluminium oxide layers deposited at temperature P1, aluminium oxide layers deposited at temperature P3 are much less susceptible to subsequent heating steps, such as an annealing step for processing a deposited cladding layer.

The morphology achieved at deposition temperatures P3 may also be described as polycrystalline aluminium oxide, saturated with nano-crystallites. Here, nano-crystallites refer to crystallites with a size that is relatively small compared to the waveguide of the light that is to travel through the optical waveguide. This morphology is advantageous because:
a) nano-crystallites are so small that they do not cause significant Rayleigh scattering due to their size;
b) saturation of the core with nano-crystallites ensures little to no fluctuations in dielectric properties throughout the core thereby also limiting Rayleigh scattering;
c) saturation of the core with nano-crystallites also means that existing nano-crystallites have little to no amorphous material in their surroundings to absorb and grow with;
d) growth occurring due to nano-crystallites mutually aligning and forming a single larger crystallite only occurs at much higher temperatures.

Graphs in figures 8a-c conceptually show when depositing an aluminium oxide layer at various substrate temperatures. While points PI, P2, and P3 are indicated in each graph, the behaviour related therein does not have to occur exactly at the same temperatures for each property described in figures 8a-c. Also, while figure 8c suggests the local minima at P1 and P3 allow for achieving the same low losses, implementations of the method according to the invention may, for a plethora of reasons, result in local minima P1 and P3 achieving different levels of losses.

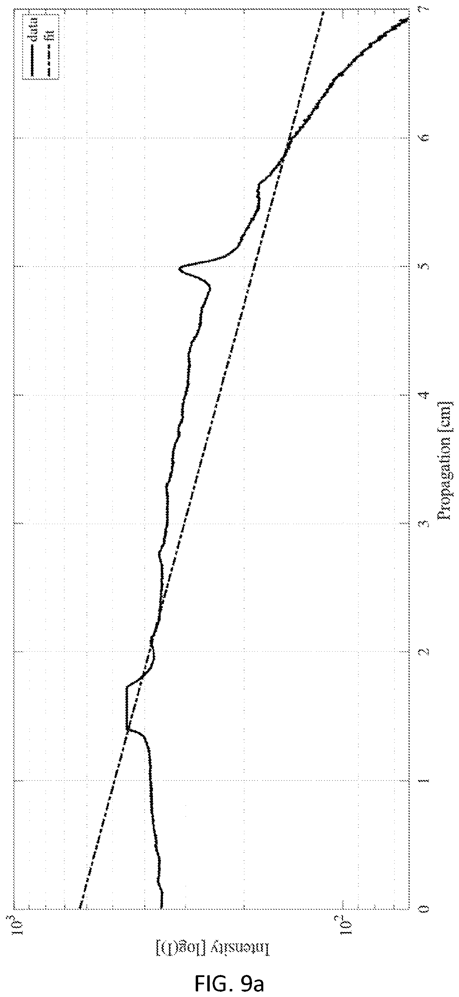

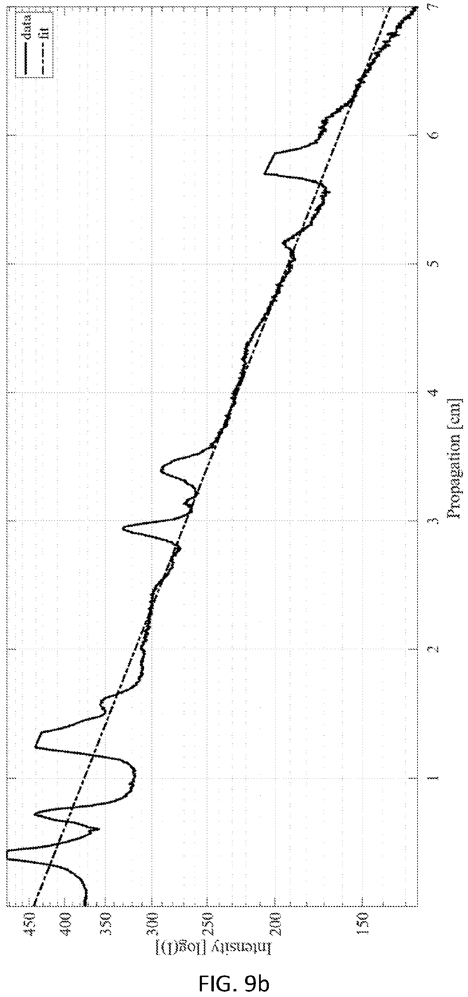

The applicant finds that subjecting aluminium oxide waveguide core 11, in which nano-crystallites are formed, to temperatures of 800 degrees or higher may even be advantageous and/or decrease losses. This is for example shown in figures 9a and 9b.

When aluminium oxide waveguide core 11 is exposed to such a temperature, while the growth of the nano-crystallites is very limited, said growth will still consume all or at least most of the amorphous aluminium oxide that may have formed during deposition of aluminium oxide waveguide core 11. After being subjected to said temperature, if less amorphous aluminium oxide is present, local differences in dielectric properties occur less often and thus scattering decreases.

For figure 9a, the aluminium oxide waveguide core in question is one deposited such that nano-crystallites are formed in the aluminium oxide. No further processing step was performed during which the deposited aluminium oxide waveguide core was subjected to a temperature of 800 degrees Celsius or more. The losses achieved are 1 +/- 0.5 dB/cm.

For figure 9b, the aluminium oxide waveguide core of figure 9a was subjected to about 1150 degrees Celsius for about four hours, in a nitrogen environment. The losses achieved are 0.7 +/-0.2 dB/cm.

The intensity of light, as given on the Y-axis, is an estimate derived from scattering light measured over the propagation length of the waveguide core. Not willing to be bound by theory, the skilled person will appreciate that due to limitations of this estimate it may seem that the intensity of the light increases, while it is still safe to say that losses do occur. These losses are estimated by fitting the measurement data to a log-linear model using a maximum likelihood estimator sample consensus, MLESAC, algorithm. The given error margins are determined by fitting different sections of the total propagation. The skilled person will appreciate that other approaches to estimate the intensity of light inside the waveguide core, and derive average losses from that measurement data may also be used.

In embodiments, when depositing an aluminium nitride waveguide core, the temperature values for P1, P2, or P3 may be different from those found for aluminium oxide waveguide cores, however the applicant does find that the same behaviour occurs. Similar changes in the phase that the aluminium nitride has (e.g. amorph or (nano-)crystalline), similar increase in size of the (nano-)crystallites, and a conceptually comparable loss profile can be identified in aluminium nitride waveguide cores, when deposited at varying temperatures. The teachings explained in figures 8a-c, and 9a-b, while explained based on the aluminium oxide waveguide core, can also be applied to the aluminium nitride embodiment.

In the above, the present invention has been explained using detailed embodiments thereof. However, it should be apparent to the skilled person that various modifications are possible to these embodiments without deviating from the scope of the present invention, which is defined by the appended claims.

### Reference Signs List

- 10: substrate
- 11: waveguide core
- 12: cladding layer
- 100: sputtering system
- 101: At target
- 102: cathode
- 103: anode
- 104: plasma
- 105: Ar atoms
- 106: Ar ions
- 107: electrons
- 108: Al atoms
- 109: Oxygen molecules
- 110: inlet
- 111: heaters

## Claims

1. A method for manufacturing an optical waveguide, the method comprising:
providing a substrate (10);
depositing an aluminium nitride waveguide core (11) on the substrate (10), and;
arranging a cladding layer (12) on the deposited aluminium nitride waveguide core (11), said arranging comprising at least one processing step during which the deposited aluminium nitride waveguide core (11) is subjected to a given maximum temperature;
**characterized in that**
depositing the aluminium nitride waveguide core (11) comprises forming nano-crystallites in the aluminium nitride waveguide core (11);
wherein a temperature the aluminium nitride waveguide core (11) would be required to have for significantly increasing a size of the formed nano-crystallites during arranging of the cladding layer (12) exceeds the given maximum temperature, wherein the given maximum temperature is 800 degrees Celsius or higher; and
**in that** the optical waveguide comprises the aluminium nitride waveguide core (11) comprising nano-crystallites that are between 1 nanometre and 30 nanometre in size, preferably between 1 nanometre and 10 nanometre in size,
wherein the nano-crystallites form at least 50% by weight of the aluminium nitride waveguide core (11), preferably at least 75%, and more preferably at least 99%, and
wherein the cladding layer (12) comprises a high-temperature cladding layer (12).

2. The method according to claim 1,
wherein an increase in size of the formed nano-crystallites is between 100% and 50%.

3. The method according to claim 1 or 2,
wherein the given maximum temperature lies in a range between 800 and 1400 degrees Celsius, preferably between 1000 and 1200 degrees Celsius, and is more preferably 1150 degrees Celsius.

4. The method according to claim 1, 2 or 3,
wherein arranging the cladding layer (12) comprises depositing the cladding layer (12) on the aluminium nitride waveguide core (11), and wherein said at least one processing step comprises annealing the combination of the substrate (10), deposited aluminium nitride waveguide core (11), and deposited cladding layer (12) at said given maximum temperature,
preferably wherein the nano-crystallites in the aluminium nitride waveguide core (11) after said deposition of the cladding layer (12) and before said annealing are between 1 nanometre and 30 nanometre in size, and preferably between 1 nanometre and 10 nanometre in size,
preferably wherein the nano-crystallites in the aluminium nitride waveguide core (11) form at least 40% by weight of the aluminium nitride waveguide core (11) after said deposition and before said annealing, preferably at least 70%, and more preferably at least 90%.

5. The method according to claim 4,
wherein the nano-crystallites in the aluminium nitride waveguide core (11) after said annealing are between 1 nanometre and 30 nanometre in size, and preferably between 1 nanometre and 10 nanometres,
preferably wherein the nano-crystallites in the aluminium nitride waveguide core (11) form at least 50% by weight of the aluminium nitride waveguide core (11) after said annealing, preferably at least 75%, and more preferably at least 99%.

6. The method according to claim 1, 2 or 3,
wherein said at least one processing step comprises depositing the cladding layer (12) on the aluminium nitride waveguide core (11) at said given maximum temperature,
preferably wherein the nano-crystallites in the aluminium nitride waveguide core (11) after depositing the cladding layer (12) are between 1 nanometre and 30 nanometre in size, and preferably between 1 nanometre and 10 nanometre in size,
preferably wherein the nano-crystallites in the aluminium nitride waveguide core (11) form at least 50% by weight of the aluminium nitride waveguide core (11) after depositing the cladding layer (12), preferably at least 75%, and more preferably at least 99%.

7. The method according to any of the previous claims,
wherein the aluminium nitride waveguide core (11) is grown using any one of reactive sputter deposition, atomic layer deposition, evaporation, or pulsed laser deposition and/or
wherein the cladding layer (12) comprises a TEOS layer, a Silicon oxynitride layer, an aluminium oxide layer, or a polymer layer and/or
wherein the cladding layer (12) is arranged using any one of plasma (104) enhanced vapor deposition, low pressure chemical vapor deposition, evaporation, sputtering, or atomic layer deposition and/or
wherein the substrate (10) comprises a silicon substrate, silicon nitride substrate, a silicon thermal oxide substrate, a quartz substrate, or a sapphire substrate.

8. The method according to any of the previous claims,
wherein the aluminium nitride waveguide core (11) is stoichiometric, and/or wherein the aluminium nitride waveguide core (11) comprises AlxNy,
wherein 0.8 〈 x 〈 1.1 and 0.9 〈 y 〈 1.2, such as x = 0.9, and y = 1.1, and preferably x = 1, and y = 1.

9. The method according to any of the previous claims,
wherein the waveguide is a slab waveguide or a channel waveguide.

10. The method according to any of the previous claims, further including,
between depositing the aluminium nitride waveguide core (11) and arranging the cladding layer (12), reducing surface roughness of the aluminium nitride waveguide core (11) using chemical mechanical polishing.

11. The method according to any of the previous claims, further comprising
defining a shape and/or size of the aluminium nitride waveguide core (11) using at least one of lithography and etching, before arranging the cladding layer (12).

12. The method according to any of the previous claims, comprising:
at a deposition rate for aluminium nitride, depositing aluminium nitride layers at varying substrate temperatures and/or at varying substrate bias voltages on respective substrates (10);
for each deposited aluminium nitride layer, measuring its optical performance;
selecting, as optimal settings, said deposition rate and the substrate (10) temperature and substrate (10) bias voltage with which the aluminium nitride layer was manufactured that had the best optical performance;
using the optimal settings when depositing the aluminium nitride waveguide core (11) for manufacturing an optical waveguide according to any of the preceding claims.

13. An optical waveguide, manufactured according to any one of the preceding claims, comprising:
a substrate (10); an aluminium nitride waveguide core (11) arranged on the substrate (10);
and a cladding layer (12) arranged on the aluminium nitride waveguide core (11);
**characterized in that**
the aluminium nitride waveguide core (11) comprises nano-crystallites that are between 1 nanometre and 30 nanometre in size, preferably between 1 nanometre and 10 nanometre in size,
wherein the nano-crystallites form at least 50% by weight of the aluminium nitride waveguide core (11), preferably at least 75%, and more preferably at least 99%, and
wherein the cladding layer (12) comprises a high- temperature cladding layer (12).

14. The optical waveguide according to claim 13,
wherein the high-temperature cladding layer (12) comprises at least one a TEOS layer or a Silicon oxynitride layer.

15. The optical waveguide according to claim 13 or 14,
wherein the waveguide is a slab waveguide or a channel waveguide.

## Patentansprüche

1. Verfahren zur Herstellung eines Lichtwellenleiters, wobei das Verfahren umfasst:
Bereitstellen eines Substrats (10);
Abscheiden eines Aluminiumnitrid-Wellenleiterkerns (11) auf dem Substrat (10), und;
Anordnen einer Mantelschicht (12) auf dem abgeschiedenen Aluminiumnitrid-Wellenleiterkern (11), wobei das Anordnen mindestens einen Verarbeitungsschritt umfasst, bei dem der abgeschiedene Aluminiumnitrid-Wellenleiterkern (11) einer bestimmten Höchsttemperatur ausgesetzt wird;
**dadurch gekennzeichnet, dass**
das Abscheiden des Aluminiumnitrid-Wellenleiterkerns (11) umfasst, Nanokristallite in dem Aluminiumnitrid-Wellenleiterkern (11) zu bilden;
wobei eine Temperatur, die der Aluminiumnitrid-Wellenleiterkern (11) haben müsste, um beim Anordnen der Mantelschicht (12) eine Größe der gebildeten Nanokristallite deutlich zu erhöhen, die bestimmte Höchsttemperatur übersteigt, wobei die bestimmte Höchsttemperatur ca. 800 Grad Celsius oder mehr beträgt; und
**dadurch, dass** der Lichtwellenleiter den Aluminiumnitrid-Wellenleiterkern (11) aufweist, der Nanokristallite aufweist, die zwischen 1 Nanometer und 30 Nanometer, vorzugsweise zwischen 1 Nanometer und 10 Nanometer groß sind,
wobei die Nanokristallite mindestens 50 Gew.-% des Aluminiumnitrid-Wellenleiterkerns (11) bilden, vorzugsweise mindestens 75% und noch bevorzugter mindestens 99%, und wobei die Mantelschicht (12) eine Hochtemperaturmantelschicht (12) aufweist.

2. Verfahren nach Anspruch 1, wobei eine Größenzunahme der gebildeten Nanokristallite zwischen 100% und 50% beträgt.

3. Verfahren nach Anspruch 1 oder 2,
wobei die bestimmte Höchsttemperatur in einem Bereich zwischen 800 und 1400 Grad Celsius, vorzugsweise zwischen 1000 und 1200 Grad Celsius liegt, und noch bevorzugter 1150 Grad Celsius beträgt.

4. Verfahren nach Anspruch 1, 2 oder 3,
wobei das Anordnen der Mantelschicht (12) ein Abscheiden der Mantelschicht (12) auf dem Aluminiumnitrid-Wellenleiterkern (11) umfasst, und wobei der mindestens eine Verarbeitungsschritt ein Tempern der Kombination aus dem Substrat (10), dem abgeschiedenen Aluminiumnitrid-Wellenleiterkern (11) und der abgeschiedenen Mantelschicht (12) bei der bestimmten Höchsttemperatur umfasst,
vorzugsweise wobei die Nanokristallite in dem Aluminiumnitrid-Wellenleiterkern (11) nach der Abscheidung der Mantelschicht (12) und vor dem Tempern zwischen 1 Nanometer und 30 Nanometer, vorzugsweise zwischen 1 Nanometer und 10 Nanometer groß sind,
vorzugsweise wobei die Nanokristallite in dem Aluminiumnitrid-Wellenleiterkern (11) nach der Abscheidung und vor dem Tempern mindestens 40 Gew.-% des Aluminiumnitrid-Wellenleiterkerns (11), vorzugsweise mindestens 70% und noch bevorzugter mindestens 90%, bilden.

5. Verfahren nach Anspruch 4,
wobei die Nanokristallite in dem Aluminiumnitrid-Wellenleiterkern (11) nach dem Tempern zwischen 1 Nanometer und 30 Nanometer und vorzugsweise zwischen 1 Nanometer und 10 Nanometer groß sind,
vorzugsweise wobei die Nanokristallite in dem Aluminiumnitrid-Wellenleiterkern (11) nach dem Tempern mindestens 50 Gew.-% des Aluminiumnitrid-Wellenleiterkerns (11), vorzugsweise mindestens 75% und noch bevorzugter mindestens 99%, bilden.

6. Verfahren nach Anspruch 1, 2 oder 3,
wobei der mindestens eine Verarbeitungsschritt das Abscheiden der Mantelschicht (12) auf dem Aluminiumnitrid-Wellenleiterkern (11) bei der bestimmten Höchsttemperatur umfasst,
vorzugsweise wobei die Nanokristallite in dem Aluminiumnitrid-Wellenleiterkern (11) nach dem Abscheiden der Mantelschicht (12) zwischen 1 Nanometer und 30 Nanometer und vorzugsweise zwischen 1 Nanometer und 10 Nanometer groß sind,
vorzugsweise wobei die Nanokristallite in dem Aluminiumnitrid-Wellenleiterkern (11) nach dem Abscheiden der Mantelschicht (12) mindestens 50 Gew.-% des Aluminiumnitrid-Wellenleiterkerns (11), vorzugsweise mindestens 75% und noch bevorzugter mindestens 99%, bilden.

7. Verfahren nach einem der vorhergehenden Ansprüche,
wobei der Aluminiumnitrid-Wellenleiterkern (11) mittels reaktiver Sputterabscheidung, atomarer Schichtabscheidung, Aufdampfen oder Impulslaserabscheidung aufgezogen wird und/oder
wobei die Mantelschicht (12) eine TEOS-Schicht, eine Siliziumoxynitridschicht, eine Aluminiumoxidschicht oder eine Polymerschicht aufweist und/oder
wobei die Mantelschicht (12) durch mit Plasma (104) verstärkte Dampfabscheidung, chemische Niederdruckdampfabscheidung, Aufdampfen, Sputtern oder atomare Schichtabscheidung angeordnet wird und/oder
wobei das Substrat (10) ein Siliziumsubstrat, ein Siliziumnitridsubstrat, ein Siliziumsubstrat mit thermischem Oxid, ein Quarzsubstrat oder ein Saphirsubstrat aufweist.

8. Verfahren nach einem der vorhergehenden Ansprüche,
wobei der Aluminiumnitrid-Wellenleiterkern (11) stöchiometrisch ist, und/oder
wobei der Aluminiumnitrid-Wellenleiterkern (11) AlxNy aufweist,
wobei 0,8 < x < 1,1 und 0,9 < y < 1,2 gilt, wie etwa x = 0,9 und y = 1,1 und vorzugsweise x = 1 und y = 1.

9. Verfahren nach einem der vorhergehenden Ansprüche,
wobei der Wellenleiter ein Schichtwellenleiter oder ein Kanalwellenleiter ist.

10. Verfahren nach einem der vorhergehenden Ansprüche, darüber hinaus umfassend, zwischen dem Abscheiden des Aluminiumnitrid-Wellenleiterkerns (11) und dem Anordnen der Mantelschicht (12), die Oberflächenrauigkeit des Aluminiumnitrid-Wellenleiterkerns (11) durch chemisch-mechanisches Polieren zu reduzieren.

11. Verfahren nach einem der vorhergehenden Ansprüche, darüber hinaus umfassend, vor dem Anordnen der Mantelschicht (12) eine Form und/oder Größe des Aluminiumnitrid-Wellenleiterkerns (11) mithilfe von Lithographie und/oder Ätzen zu definieren.

12. Verfahren nach einem der vorhergehenden Ansprüche, umfassend:
bei einer Abscheidungsrate für Aluminiumnitrid, Abscheiden von Aluminiumnitridschichten bei verschiedenen Substrattemperaturen und/oder verschiedenen Substratvorspannungen an jeweiligen Substraten (10);
für jede abgeschiedene Aluminiumnitridschicht, Messen ihres optischen Verhaltens;
Auswählen, als optimale Einstellungen, derjenigen Abscheidungsrate und Temperatur und Vorspannung des Substrats (10), bei denen die Aluminiumnitridschicht hergestellt wurde, die das beste optische Verhalten hatte;
Verwenden der optimalen Einstellungen beim Abscheiden des Aluminiumnitrid-Wellenleiterkerns (11) zur Herstellung eines Lichtwellenleiters nach einem der vorhergehenden Ansprüche.

13. Lichtwellenleiter, der nach einem der vorhergehenden Ansprüche hergestellt wird, aufweisend:
ein Substrat (10);
einen Aluminiumnitrid-Wellenleiterkern (11), der auf dem Substrat (10) angeordnet ist; und
eine Mantelschicht (12), die auf dem Aluminiumnitrid-Wellenleiterkern (11) angeordnet ist;
**dadurch gekennzeichnet, dass**
der Aluminiumnitrid-Wellenleiterkern (11) Nanokristallite aufweist, die zwischen 1 Nanometer und 30 Nanometer, vorzugsweise zwischen 1 Nanometer und 10 Nanometer groß sind,
wobei die Nanokristallite mindestens 50 Gew.-% des Aluminiumnitrid-Wellenleiterkerns (11) bilden, vorzugsweise mindestens 75% und noch bevorzugter mindestens 99%, und wobei die Mantelschicht (12) eine Hochtemperaturmantelschicht (12) aufweist.

14. Lichtwellenleiter nach Anspruch 13,
wobei die Hochtemperaturmantelschicht (12) eine TEOS-Schicht und/oder eine Siliziumoxynitridschicht aufweist.

15. Lichtwellenleiter nach Anspruch 13 oder 14,
wobei der Wellenleiter ein Schichtwellenleiter oder ein Kanalwellenleiter ist.

## Revendications

1. Procédé de fabrication d'un guide d'ondes optique, le procédé comprenant :
la fourniture d'un substrat (10) ;
le dépôt d'un cœur de guide d'ondes en nitrure d'aluminium (11) sur le substrat (10) ; et
l'agencement d'une couche de gainage (12) sur le cœur de guide d'ondes en nitrure d'aluminium (11) déposé, ledit agencement comprenant au moins une étape de traitement lors de laquelle le cœur de guide d'ondes en nitrure d'aluminium (11) déposé est soumis à une température maximale donnée ;
**caractérisé en ce que**
le dépôt du cœur de guide d'ondes en nitrure d'aluminium (11) comprend la formation de nanocristallites dans le cœur de guide d'ondes en nitrure d'aluminium (11) ;
sachant qu'une température à laquelle le cœur de guide d'ondes en nitrure d'aluminium (11) devrait être porté pour augmenter de manière significative une taille des nanocristallites formées lors de l'agencement de la couche de gainage (12) dépasse la température maximale donnée, sachant que la température maximale donnée est de 800 degrés Celsius ou plus ; et
**en ce que** le guide d'ondes optique comprend le cœur de guide d'ondes en nitrure d'aluminium (11) comprenant des nanocristallites ayant une taille comprise entre 1 nanomètre et 30 nanomètres, de préférence entre 1 nanomètre et 10 nanomètres,
sachant que les nanocristallites représentent au moins 50 % en poids du cœur de guide d'ondes en nitrure d'aluminium (11), de préférence au moins 75 %, et plus préférablement au moins 99 %, et sachant que la couche de gainage (12) comprend une couche de gainage à haute température (12).

2. Le procédé selon la revendication 1,
sachant qu'une augmentation en taille des nanocristallites formées est comprise entre 100 % et 50 %.

3. Le procédé selon la revendication 1 ou 2,
sachant que la température maximale donnée est située dans une plage comprise entre 800 et 1400 degrés Celsius, de préférence entre 1000 et 1200 degrés Celsius, et est plus préférablement de 1150 degrés Celsius.

4. Le procédé selon la revendication 1, 2 ou 3,
sachant que l'agencement de la couche de gainage (12) comprend le dépôt de la couche de gainage (12) sur le cœur de guide d'ondes en nitrure d'aluminium (11), et sachant que ladite au moins une étape de traitement comprend le recuit de la combinaison du substrat (10), du cœur de guide d'ondes en nitrure d'aluminium (11) déposé, et de la couche de gainage (12) déposée à ladite température maximale donnée,
de préférence sachant que les nanocristallites dans le cœur de guide d'ondes en nitrure d'aluminium (11) après ledit dépôt de la couche de gainage (12) et avant ledit recuit ont une taille comprise entre 1 nanomètre et 30 nanomètres, et de préférence entre 1 nanomètre et 10 nanomètres,
de préférence sachant que les nanocristallites dans le cœur de guide d'ondes en nitrure d'aluminium (11) représentent au moins 40 % en poids du cœur de guide d'ondes en nitrure d'aluminium (11) après ledit dépôt et avant ledit recuit, de préférence au moins 70 %, et plus préférablement au moins 90 %.

5. Le procédé selon la revendication 4,
sachant que les nanocristallites dans le cœur de guide d'ondes en nitrure d'aluminium (11) après ledit recuit ont une taille comprise entre 1 nanomètre et 10 nanomètres, et de préférence entre 1 nanomètre et 10 nanomètres,
de préférence sachant que les nanocristallites dans le cœur de guide d'ondes en nitrure d'aluminium (11) représentent au moins 50 % en poids du cœur de guide d'ondes en nitrure d'aluminium (11) après ledit recuit, de préférence au moins 75 %, et plus préférablement au moins 99 %.

6. Le procédé selon la revendication 1, 2 ou 3,
sachant que ladite au moins une étape de traitement comprend le dépôt de la couche de gainage (12) sur le cœur de guide d'ondes en nitrure d'aluminium (11) à ladite température maximale donnée,
de préférence sachant que les nanocristallites dans le cœur de guide d'ondes en nitrure d'aluminium (11) après le dépôt de la couche de gainage (12) ont une taille comprise entre 1 nanomètre et 30 nanomètres, et de préférence entre 1 nanomètre et 10 nanomètres,
de préférence sachant que les nanocristallites dans le cœur de guide d'ondes en nitrure d'aluminium (11) représentent au moins 50 % en poids du cœur de guide d'ondes en nitrure d'aluminium (11) après le dépôt de la couche de gainage (12), de préférence au moins 75 %, et plus préférablement au moins 99 %.

7. Le procédé selon l'une quelconque des revendications précédentes,
sachant que le cœur de guide d'ondes en nitrure d'aluminium (11) est élaboré moyennant l'un quelconque des procédés suivants : dépôt par pulvérisation réactive, dépôt par couches atomiques, évaporation, ou dépôt par laser pulsé et/ou
sachant que la couche de gainage (12) comprend une couche de TEOS, une couche d'oxynitrure de silicium, une couche d'oxyde d'aluminium, ou une couche de polymère et/ou
sachant que la couche de gainage (12) est agencée moyennant l'un quelconque des procédés suivants : dépôt en phase vapeur assisté par plasma (104), dépôt chimique en phase vapeur à basse pression, évaporation, pulvérisation, ou dépôt par couches atomiques et/ou
sachant que le substrat (10) comprend un substrat en silicium, un substrat en nitrure de silicium, un substrat en oxyde thermique de silicium, un substrat en quartz, ou un substrat en saphir.

8. Le procédé selon l'une quelconque des revendications précédentes,
sachant que le cœur de guide d'ondes en nitrure d'aluminium (11) est stœchiométrique, et/ou
sachant que le cœur de guide d'ondes en nitrure d'aluminium (11) comprend de l'AlxNy,
sachant que 0,8 < x < 1,1 et 0,9 < y < 1,2, tel que x = 0,9, et y = 1,1, et de préférence x = 1, et y = 1.

9. Le procédé selon l'une quelconque des revendications précédentes,
sachant que le guide d'ondes est un guide d'ondes plan ou un guide d'ondes à canal.

10. Le procédé selon l'une quelconque des revendications précédentes, incluant en outre, entre le dépôt du cœur de guide d'ondes en nitrure d'aluminium (11) et l'agencement de la couche de gainage (12), la réduction de la rugosité de surface du cœur de guide d'ondes en nitrure d'aluminium (11) moyennant un polissage chimico-mécanique.

11. Le procédé selon l'une quelconque des revendications précédentes, comprenant en outre la définition d'une forme et/ou d'une taille du cœur de guide d'ondes en nitrure d'aluminium (1) moyennant au moins l'un des procédés suivants : lithographie et gravure, avant l'agencement de la couche de gainage (12).

12. Le procédé selon l'une quelconque des revendications précédentes, comprenant :
à un taux de dépôt pour le nitrure d'aluminium, le dépôt de couches de nitrure d'aluminium à des températures de substrat variables et/ou à des tensions polarisation de substrat variables sur des substrats (10) respectifs ;
pour chaque couche de nitrure d'aluminium déposée, la mesure de sa performance optique ;
la sélection, comme paramètres optimaux, dudit taux de dépôt et de la température de substrat (10) et de la tension de polarisation de substrat (10) auxquels la couche de nitrure d'aluminium ayant présenté la meilleure performance optique a été fabriquée ;
l'utilisation des paramètres optimaux lors du dépôt du cœur de guide d'ondes en nitrure d'aluminium (11) pour fabriquer un guide d'ondes optique selon l'une quelconque des revendications précédentes.

13. Guide d'ondes optique, fabriqué selon l'une quelconque des revendications précédentes, comprenant :
un substrat (10) ;
un cœur de guide d'ondes en nitrure d'aluminium (11) agencé sur le substrat (10) ; et
une couche de gainage (12) agencée sur le cœur de guide d'ondes en nitrure d'aluminium (11) ;
**caractérisé en ce que**
le cœur de guide d'ondes en nitrure d'aluminium (11) comprend des nanocristallites ayant une taille comprise entre 1 nanomètre et 30 nanomètres, de préférence entre 1 nanomètre et 10 nanomètres,
sachant que les nanocristallites représentent au moins 50 % en poids du cœur de guide d'ondes en nitrure d'aluminium (11), de préférence au moins 75 %, et plus préférablement au moins 99 %, et sachant que la couche de gainage (12) comprend une couche de gainage à haute température (12).

14. Le guide d'ondes optique selon la revendication 13,
sachant que la couche de gainage à haute température (12) comprend au moins l'une parmi une couche de TEOS ou une couche d'oxynitrure de silicium.

15. Le guide d'ondes optique selon la revendication 13 ou 14,
sachant que le guide d'ondes est un guide d'ondes plan ou un guide d'ondes à canal.
